# EUROPÄISCHE PATENTSCHRIFT

(11) **EP 2 596 157 B1**
(45) Veröffentlichungstag und Bekanntmachung des Hinweises auf die Patenterteilung: **19.11.2014**
(21) Anmeldenummer: 12717606.3
(22) Anmeldetag: 21.04.2012
(51) Int. Cl.: C25D 3/60, C25D 5/08, C25D 7/00, H05K 3/30, H01R 12/58, H01R 4/58, H01R 13/03, H01R 13/17, H01R 12/70

(54) **EINPRESSPIN UND VERFAHREN ZU SEINER HERSTELLUNG**
PRESS-FIT CONTACT AND METHOD OF PRODUCTION THEREOF
BROCHE À INSERTION ET SON PROCÉDÉ DE FABRICATION

(30) Priorität: 13.05.2011 DE 102011101602
(43) Veröffentlichungstag der Anmeldung: 29.05.2013
(73) Patentinhaber: Enayati GmbH&Co. Kg Oberflächen- Und Anlagentechnik, 75217 Birkenfeld (DE)
(72) Erfinder: DREIßIGACKER, Uwe, 75331 Engelsbrand (DE)
(74) Vertreter: Schön, Thilo
(86) Internationale Anmeldenummer: PCT/EP2012/001733
(87) Internationale Veröffentlichungsnummer: WO 2012/156021

(56) Entgegenhaltungen:
- WO-A2-2009/117639
- DE-A1-102005 055 742
- DE-A1-102007 014 356
- US-B1- 6 361 823
- US-B1- 7 780 483
- GANESAU S ET AL: "Assessment of long-term reliability in lead-free assemblies", ASIAN GREEN ELECTRONICS, 2005. AGEC. PROCEEDINGS OF 2005 INTERNATIONAL CONFERENCE ON SHANGHAI, CHINA MARCH 15-18, 2005, PISCATAWAY, NJ, USA,IEEE, 15. März 2005 (2005-03-15), Seiten 140-155, XP010807577, DOI: 10.1109/AGEC.2005.1452334 ISBN: 978-0-7803-8806-2

## Beschreibung

### Technisches Gebiet der Erfindung

Die Erfindung betrifft einen Einpresspin nach Anspruch 1 und ein Verfahren zu seiner Herstellung nach Anspruch 8.

Dauerhafte, lotfreie elektrische Kontakte sind in der Technik weiter verbreitet. Es sind insbesondere sogenannte elektrische Einpressverbindung bekannt, welche dadurch hergestellt werden, dass ein Einpresspin in das durchkontaktierte Loch einer Leiterplatte gepresst und dabei eine gasdichte elektrische Verbindung erzeugt wird. Die Wandung des durchkontaktierten Lochs besteht in der Regel aus einer Kupferhülse, der Einpresspin besteht beispielsweise aus einer Kupferlegierung . Der Einpresspin weist eine sogenannte Einpresszone auf, über welche der Kontakt zum durchkontaktierten Loch hergestellt wird und welche elastisch deformierbar ausgebildet sein kann. Häufig trägt ein Bauteil, beispielsweise ein Stecker, eine Vielzahl von zueinander parallelen Einpresspins, welche bei der Montage dieses Bauteils an einer Leiterplatte alle gleichzeitig eingepresst werden. Darum muss die Leiterplatte beim Einpressen, trotz ihrer teilweise recht filigranen Struktur, oft erhebliche mechanische Belastungen aufnehmen können.

### Stand der Technik

Je nach Gestaltung des Einpresspins und/oder seiner Einpresszone unterscheidet man zwischen flexiblen und massiven Einpresszonen. Ein Einpresspin mit einer flexiblen Einpresszone ist beispielsweise in der DE 198 31 672 B4 beschrieben. Im Falle flexibler Einpresszonen handelt es sich um Einpresspins mit gezielt eingestellten elastischen Eigenschaften, so dass die mechanischen Kräfte während des Einpressens in erster Linie durch den Einpresspin selbst aufgenommen werden.

Beim Einpressvorgang muss sich eine gasdichte Zone bilden. Hierzu wird eine weitere Schicht - typischerweise ein Reinzinnschicht - auf die Kupferhülse mit ausreichender Schichtdicke aufgebracht. Dies geschieht in der Regel mittels chemischer Verzinnung. Die chemische Verzinnung bietet günstige Gleiteigenschaften beim Einpressvorgang ("Schmierwirkung") und trägt somit auch zur Reduzierung der Einpresskräfte bei.

In der Regel wird auch eine dünne Beschichtung zumindest im Bereich der Einpresszone auf den Einpresspin aufgebracht. Die Beschichtung kann zinnhaltig sein, um die Gleiteigenschaften der Einpresszone zu verbessern. Ein Einpresspin mit einer Beschichtung ist beispielsweise in der DE 10 2006 057 143 A1 beschrieben. Der Auftrag dieser Zinnschicht erfolgt in der Regel auf galvanischem Weg.

Bis vor einigen Jahren war die Beschichtung auf der Einpresszone des Pins in der Regel eine Blei-Zinn-Schicht. Aufgrund von verschärften Umweltvorschriften, insbesondere der RoHS (Restriction of certain Hazardous Substances) EU-Richtlinie 2002/95/EC, ist der Einsatz von Blei nicht mehr möglich. Es wurde deshalb auf bleifreie Zinnschichten umgestellt. Durch diese Umstellung von Zinn-Blei- auf bleifreie Zinnschichten kommt es vermehrt zu Problemen wegen der Bildung von sogenannten Whiskern. Whisker sind Einkristalle welche aus der Beschichtung herauswachsen und im Falle von elektrischen Verbindungen bis zu einigen Millimetern lang werden und zu Kurzschlüssen führen können. Whisker bilden sich oft erst nach Jahren des Betriebs und ein durch einen Whisker verursachter Kurzschluss tritt ohne Vorwarnung auf. Whiskerbildung ist beispielsweise häufig für den plötzlichen Ausfall der Elektronik eines Kraftfahrzeugs verantwortlich. Im schlimmsten Fall fällt das Fahrzeug aufgrund einer solchen Whiskerbildung vollständig aus und kann nur in einer Fachwerkstatt durch Austausch der betroffenen Leiterplatte wieder in fahrbereiten Zustand versetzt werden.

In der gattungsbildenden US 2009/0239398 A1 ist ein Einpress-Pin beschrieben, auf welchem zur Vermeidung von Whiskern eine Zinn-Silber-Schicht mit einem

Silberanteil von 0,5 bis 15 %, Rest Silber aufgebracht ist. Es werden verschiedene Verfahren vorgeschlagen, wie diese Schicht aufgebracht werden kann, unter anderem Galvanisieren.

Es hat sich herausgestellt, dass eine galvanisch aufgetragene Schicht, wie sie in der US 2009/0239398 A1 beschrieben ist gegenüber einer reinen Zinnbeschichtung zwar ein reduziertes Whiskerwachstum zeigt, dass dieses für viele Anwendungen, insbesondere im Automobilbau, jedoch immer noch inakzeptabel hoch ist.

In der DE 10 2005 055 742 A1 ist eine kontaktgeeignete Schicht, insbesondere für Schalter und Stecker beschrieben, welche aus einer Zinn-Matrix mit eingebetteten Silber/Zinn-Phasen besteht. Diese kontaktgeeignete Schicht soll die Verschleißeigenschaften der kontaktgeeigneten Schicht verbessern.

Die US 6,361,823 B1 schlägt ein zweischichtiges Lötpad vor, dessen äußere Lage eine Zinn-Silber-Beschichtung mit hohem Silberanteil sein kann.

### Gegenstand der Erfindung

Hiervon ausgehend stellt sich die vorliegende Erfindung die Aufgabe, einen gattungsgemäßen Einpresspin dahingehend zu verbessern, dass das Whiskerwachstum auf ein auch für den Automobilbau akzeptables Maß, das heißt nahe null, reduziert wird.

Diese Aufgabe wird durch einen Einpresspin mit den Merkmalen des Anspruchs 1 gelöst, bei bevorzugtes Herstellungsverfahren ist in Anspruch 8 angegeben.

Es hat sich herausgestellt, dass entgegen der Versuche, welche entsprechend der US 2009/0239398 A1 durchgeführt wurden, Zinn-Silber-Beschichtungen doch zu einer Whiskerreduzierung im gewünschten Maß führen können, jedoch nur, wenn der Silberanteil sehr viel höher liegt, als in der US 2009/0239398 A1 vorgeschlagen.

Es hat sich weiterhin herausgestellt, dass das Silber, oder ein Teil desselben, durch Kupfer oder Bismut ersetzt werden kann.

Dementsprechend besteht der Einpresspin aus einem Grundkörper und einer Beschichtung, welche sich zumindest auf der Einpresszone des Grundkörpers befindet, wobei diese Beschichtung aus einer Zinnlegierung mit einem sehr hohen Anteil wenigstens eines der Metalle Silber, Kupfer oder Bismut, im folgenden Legierungsmetalle genannt, besteht. Der Anteil dieser Legierungsmetalle beträgt zwischen 30 und 72 Massenprozent. In einer besonders bevorzugten Ausführungsform wird als Legierungsmetall ausschließlich Silber eingesetzt.

Ein Einpresspin mit der erfindungsgemäßen Beschichtung zeigt gegenüber einem Einpresspin mit einer Reinzinnbeschichtung nicht nur ein deutlich reduziertes Whiskerwachstum, die erfindungsgemäße Beschichtung hat auch eine positive Wirkung auf die Gleit- und somit Verschleißeigenschaften der beteiligten Steckpartner.

Die Beschichtung wird vorzugsweise galvanisch, weiter vorzugsweise aus einem stark sauren galvanischen Zinn-Silber-Legierungselektrolyten abgeschieden, wodurch eine feinkristalline Legierungen entsteht.

Vorzugsweise hat die Beschichtung eine Dicke zwischen 0,25 und 0,6 Micrometer.

Vorzugsweise erfolgt die galvanische Beschichtung in einer Durchlaufanlage (Bandgalvanik), vorzugsweise bei einer Stromdichte von 0,5 - 10 A/dm².

Die Erfindung wird nun anhand eines Ausführungsbeispiels mit Bezug auf die Figuren näher beschrieben. Es zeigen:
- Figur 1: einen Einpresspin
- Figur 2: das Detail D aus Figur 1
- Figur 3: eine schematische Darstellung einer Zelle einer Bandgalvanik anlage.

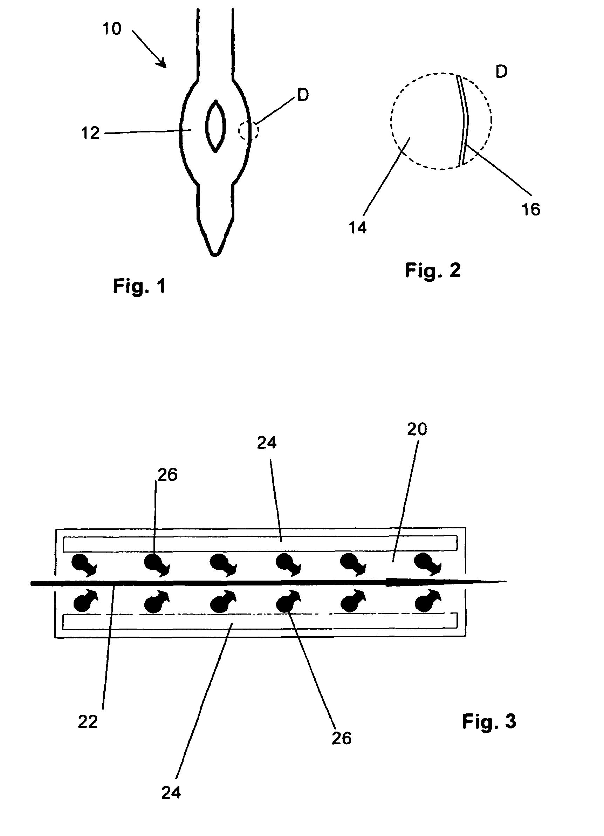

Die Figur 1 zeigt einen Einpresspin 10 mit einer Einpresszone 12, welche in Form von zwei durch einen Zwischenraum getrennten Schenkeln 12 ausgebildet ist. Es handelt sich also um eine flexible Einpresszone. Der Einpresspin 10 besteht aus einem Grundkörper 14 vorzugsweise aus Kupfer oder einer Kupferlegierung und einer zumindest im Bereich der Einpresszone auf den Grundkörper 14 aufgetragenen Beschichtung 16, wie dies in der nicht maßstäblichen Darstellung der Figur 2 dargestellt ist. Die Schichtdicke dieser Beschichtung beträgt vorzugsweise zwischen 0,25 und 0,6 µm. Die Beschichtung besteht im gezeigten Ausführungsbeispiel aus einer Zinn-Silberlegierung mit einem Silberanteil von > 30 %, vorzugsweise ca. 40%.

Der Auftrag der Beschichtung erfolgt auf galvanischem Wege, vorzugsweise in einer Bandgalvanikanlage, bei der ein bandförmiges Stanzgitter, in welchem die Einpresspins in einem noch nicht vollständig ausgestanzten Zustand gehalten sind, durch mehrere hintereinander liegende Zellen 20 (s. Figur 3) gezogen wird. Der Elektrolyt ist wässrige Methansulfonsäure, in welcher die Zinn- und die Silberionen gelöst sind. Der Elektrolyt wird in der Zelle in einem Kreislauf gepumpt, wobei die Zuführung in die Zelle 20 über Düsen 26 erfolgt, welche auf das Band 22 zuweisen, jedoch schräg in Richtung der Bewegungsrichtung des Bandes 22.

Die Silberionen werden vorzugsweise in flüssiger Form, die Zinnionen werden vorzugsweise in Form von Zinnmethansulfonat und durch die Löslichkeit der Zinnanoden zugegeben. Ein geeignetes Material für die Anoden 24 ist Reinzinn.

## Patentansprüche

1. Einpresspin (10) mit einem Grundkörper (14) und einer den Grundkörper zumindest abschnittsweise bedeckenden Beschichtung (16), wobei die Beschichtung eine Zinnlegierung ist,
**dadurch gekennzeichnet, dass** die Zinnlegierung der Beschichtung (16) zu 30 bis 72 Massenprozent aus Silber und/oder Kupfer und/oder Bismut (Legierungsmetalle), Rest Zinn und Verunreinigungen besteht.

2. Einpresspin (10) nach Anspruch 1, **dadurch gekennzeichnet, dass** die Beschichtung (16) galvanisch auf dem Grundkörper (14) abgeschieden ist.

3. Einpresspin (10) nach Anspruch 2, **dadurch gekennzeichnet, dass** der Massenanteil der Legierungsmetalle Silber, Kupfer und Bismut 40 bis 72 Massenprozent beträgt.

4. Einpresspin nach einem der vorangehenden Ansprüchen, **dadurch gekennzeichnet, dass** die Beschichtung ausschließlich aus Zinn, Silber und Verunreinigungen besteht.

5. Einpresspin nach Anspruch 1, **dadurch gekennzeichnet, dass** die Verunreinigungen weniger als 0,1 Massenprozent betragen.

6. Einpresspin nach Anspruch 5, **dadurch gekennzeichnet, dass** die Verunreinigungen weniger als 0,05 Massenprozent betragen.

7. Einpresspin nach einem der vorangehenden Ansprüche, **dadurch gekennzeichnet, dass** die Beschichtung (16) eine Dicke zwischen 0,25 und 0,6 Micrometer aufweist.

8. Verfahren zur Herstellung eines Einpresspins nach einem der Ansprüche 1 bis 7, wobei das Zinn und das wenigstens eine Legierungsmetall aus
methansulfonsaurer Lösung galvanisch auf dem Grundkörper (14) abgeschieden wird.

9. Verfahren nach Anspruch 8, **dadurch gekennzeichnet, dass** die galvanische Abscheidung bei sich durch eine Zelle (20) bewegendem Einpresspin erfolgt, wobei der Elektrolyt umgepumpt wird und in Bewegungsrichtung des Einpresspins gerichtet auf den Einpresspin der Zelle (20) zugeführt wird.

10. Verfahren nach Anspruch 9, **dadurch gekennzeichnet, dass** der Einpresspin Teil eines bandförmigen Stanzgitters ist, welches durch die Zelle bewegt wird.

## Claims

1. A press-fit contact (10) having a main body (14) and a coating (16) which covers at least a section of the main body, the coating being a tin alloy, **characterised in that** 30 to 72% by mass of the tin alloy of the coating (16) consists of silver and/or copper and/or bismuth (alloy metals), the rest being tin and impurities.

2. The press-fit contact (10) of claim 1 wherein the coating (16) is deposited on the main body (14) galvanically.

3. The press-fit contact (10) of claim 2 wherein the mass fraction of the alloy metals silver, copper and bismuth is 40 to 72% by mass.

4. The press-fit contact of any one of the preceding claims wherein the coating consists exclusively of tin, silver and impurities.

5. The press-fit contact of claim 1 wherein the impurities are less than 0.1 % by mass.

6. The press-fit contact of claim 5 wherein the impurities are less than 0.05% by mass.

7. The press-fit contact of any one of the preceding claims wherein the coating (16) exhibits a thickness of between 0.25 and 0.6 micrometres.

8. A method for producing a press-fit contact according to any one of claims 1 to 7 wherein the tin and the at least one alloy metal is galvanically deposited on the main body (14) out of methane-sulfonic acid solution.

9. The method of claim 8 wherein the galvanic deposition is effected during the press-fit contact moving through a cell (20) in which the electrolyte is pumped round and fed to the cell (20) in the direction of movement of the press-fit contact directed at the press-fit contact.

10. The method of claim 9 wherein the press-fit contact is part of a band-shaped leadframe which is moved through the cell.

## Revendications

1. Broche à insertion (10) comprenant un corps principal (14) et un revêtement (16) recouvrant au moins en partie le corps principal, le revêtement étant un alliage d'étain,
**caractérisée en ce que** l'alliage d'étain du revêtement (16) est constitué de 30 à 72 pour cent en masse d'argent et/ou de cuivre et/ou de bismuth (métaux d'alliage), le reste étant de l'étain et des impuretés.

2. Broche à insertion (10) selon la revendication 1, **caractérisée en ce que** le revêtement (16) est déposé par voie galvanique sur le corps principal (14).

3. Broche à insertion (10) selon la revendication 2, **caractérisée en ce que** la proportion en masse des métaux d'alliage argent, cuivre et bismuth est de 40 à 72 pour cent en masse.

4. Broche à insertion selon l'une des revendications précédentes, **caractérisée en ce que** le revêtement est exclusivement constitué d'étain, d'argent et d'impuretés.

5. Broche à insertion selon la revendication 1, **caractérisée en ce que** les impuretés sont inférieures à 0,1 pour cent en masse.

6. Broche à insertion selon la revendication 5, **caractérisée en ce que** les impuretés sont inférieures à 0,05 pour cent en masse.

7. Broche à insertion selon l'une des revendications précédentes, **caractérisée en ce que** le revêtement (16) présente une épaisseur entre 0,25 et 0,6 micromètre.

8. Procédé de fabrication d'une broche à insertion selon l'une des revendications 1 à 7, l'étain et l'au moins un métal d'alliage sont déposés par voie galvanique sur le corps principal (14) à partir d'une solution d'acide méthane sulfonique.

9. Procédé selon la revendication 8, **caractérisé en ce que** le dépôt galvanique s'effectue lors du déplacement de la broche à insertion à travers une cellule (20), l'électrolyte étant pompé en circulation et acheminé à la cellule (20) en étant dirigé sur la broche à insertion dans une direction de déplacement de la broche à insertion.

10. Procédé selon la revendication 9, **caractérisé en ce que** la broche à
insertion fait partie d'une grille découpée en forme de bande, qui est déplacée à travers la cellule.
